# EUROPÄISCHE PATENTSCHRIFT

(11) **EP 0 784 850 B1**
(45) Veröffentlichungstag und Bekanntmachung des Hinweises auf die Patenterteilung: **08.04.1998**
(21) Anmeldenummer: 95932629.9
(22) Anmeldetag: 27.09.1995
(51) Int. Cl.: G06K 19/07, G11C 5/00

(54) **AN DATENBUS BETREIBBARE TRAGBARE DATENTRÄGERANORDNUNG**
PORTABLE DATA CARRIER ARRANGEMENT CAPABLE OF BEING OPERATED BY DATA BUSSES
AGENCEMENT PORTATIF DE SUPPORT DE DONNEES EXPLOITABLE PAR UN BUS DE DONNEES

(30) Priorität: 30.09.1994 DE 4435121
(43) Veröffentlichungstag der Anmeldung: 23.07.1997
(73) Patentinhaber: SIEMENS AKTIENGESELLSCHAFT, 80333 München (DE)
(72) Erfinder: HAFNER, Karlheinz, D-81739 München (DE); MEHRGARDT, Sönke, D-79232 March (DE)
(86) Internationale Anmeldenummer: DE9501340
(87) Internationale Veröffentlichungsnummer: WO9610825

(56) Entgegenhaltungen:
- EP-A- 0 265 227
- EP-A- 0 644 548
- NL-A- 8 700 817

## Beschreibung

In heutigen Datenverarbeitungssystemen werden Daten auf digitalen Speichermedien abgelegt. Die Ablage erfolgt dabei kurzfristig auf Festplatten bzw. Disketten und langfristig auf Disketten, Magnetbändern oder magneto-optischen Platten. Dabei erfolgt die Ablage der Speichermedien auf konventionelle Weise in einem Archiv. Der Nachteil einer solchen konventionellen Ablage besteht darin, daß die älteren und abgelegten Daten nicht off-line sind und damit nicht unmittelbar zugreifbar sind. Außerdem muß bei dieser Art der Archivierung ein Verzeichnis gepflegt werden, das Auskunft darüber gibt, auf welchem der abgelegten Exemplare die gesuchten Daten gespeichert sind. Dieses Exemplar muß dann dem Archiv entnommen und in ein geeignetes Abspielgerät eingelegt werden. Aufwendige und damit sehr teure Archivsysteme sind als Juke-box konstruiert und erledigen dieses Entnehmen und Einlegen automatisch. Aber selbst in ihnen vergeht eine lange Zeit, bis die Daten verfügbar sind.

Aus der EP-A1 0 552 078 ist eine Steckkarte für einen Mikrocomputer bekannt, die eine Leseeinrichtung für Chipkarten mit ebenen Kontakten bildet. Die Steckkarte ist an einen PCMCIA-Anschluß des Microcomputers anschließbar und weist in ihrer Oberseite zusätzliche Kontakte auf, die zur Kontaktierung der Kontakte der Chipkarte dienen, indem letztere auf die Steckkarte gelegt wird. Die Chipkarte kann beispielsweise eine Kreditkarte sein.

Die Aufgabe der vorliegenden Erfindung ist es somit, einen Datenträger anzugeben, bei dem selbst Daten, die vor längerer Zeit abgelegt wurden, sehr schnell und automatisch wieder aufgefunden werden können. Es ist eine weitere Aufgabe der Erfindung, ein Datenverarbeitungssystem anzugeben, bei dem abgelegte Dateien selbsttätig nach bestimmten Daten durchsucht werden und diese Daten in beispielsweise einer Indexdatei abgelegt werden,

Die Aufgabe wird gelöst durch eine tragbare Datenträgeranordnung, die beispielsweise durch eine Chipkarte realisiert sein kann, mit einem elektrisch programmierbaren, nichtflüchtigen Speicher, bei der Mittel vorgesehen sind, um eine Vielzahl solcher tragbaren Datenträgeranordnungen an einem Bussystem zu betreiben. Der nichtflüchtige Speicher kann dabei ein oder mehrmals durch den Benutzer beschreibbar sein.

In vorteilhafter Ausgestaltung der erfindungsgemäßen tragbaren Datenträgeranordnung sind an Oberflächen der Datenträgeranordnung Kontaktfelder derart angeordnet, daß beim Aufeinanderlegen solcher tragbaren Datenträgeranordnungen ein Kontakt zu den jeweils benachbarten tragbaren Datenträgeranordnungen und gleichzeitig zum Bussystem möglich ist.

In weiterer Ausgestaltung der tragbaren Datenträgeranordnung sind darin Mittel vorgesehen, die ein Suchen nach bestimmten Daten im nichtflüchtigen Speicher ermöglichen. In vorteilhafter Weise sind diese Suchmittel mit einem Mikroprozessor gebildet.

Die Aufgabe wird auch gelöst durch ein Datenverarbeitungssystem mit zumindest einem Adapter zur Aufnahme jeweils zumindest einer erfindungsgemäßen tragbaren Datenträgeranordnung, wobei der Adapter mit einem Bussystem des Datenverarbeitungssystems verbunden ist. In erfindungsgemäßer Weise kann auch dieser Aufnahmeadapter einen Mikroprozessor enthalten. Im Speicher einer in den Aufnahmeadapter eingelegten Datenträgeranordnung werden die aktuell anfallenden Daten des Datenverarbeitungssystems automatisch oder manuell abgelegt. Ist die Datenträgeranordnung, im folgenden Chipkarte genannt, voll, wird sie entnommen und eine neue, leere Chipkarte eingeschoben. Die bespielte Chipkarte wird in einem weiteren Adapter für Chipkartenstapel eingeschoben. In diesem Gerät sind viele Chipkarten simultan on-line angeschlossen, wobei das Gerät selbst direkt oder über ein Datennetz mit dem Datenverarbeitungssystem verbunden ist. Auf den Aufnahmeadapter für eine einzelne Chipkarte, die beschrieben werden soll und das manuelle Befördern der beschriebenen Chipkarte in den Chipkartenstapeladapter kann auch verzichtet werden. Stattdessen sind dann im angeschlossenen Chipkartenstapeladapter außer den bespielten auch leere Chipkarten vorzusehen, die automatisch und sukzessive für die aktuelle Datenablage herangezogen werden.

Die Suche nach archivierten Daten kann über eine zentrale Steuereinheit, die z.B. mit einem Mikroprozessor nebst Programmspeicher realisiert sein kann, im Stapeladapter erfolgen. Dabei werden von diesem Master-Prozessor der Reihe nach alle Karten durchsucht. Zur Beschleunigung dieses unter Umständen sehr lang dauernden Vorgangs kann aber auch jede Chipkarte mit einer eigenen lokalen Suchlogik, die ebenfalls mit einem Mikroprozessor nebst Programmspeicher realisiert sein kann, versehen sein. Suchanfragen werden dann von dem Master-Prozessor gleichzeitig an alle angeschlossenen Chipkarten weitergegeben z.B. durch Broadcasting der Suchfrage. Der Slave-Prozessor einer jeden Chipkarte durchsucht daraufhin den lokalen Datenspeicher. Der Slave-Prozessor meldet Treffer entweder aktiv oder aber passiv auf Anfrage an den Master-Prozessor zurück, dieser wiederum meldet das Resultat an den anfragenden Zentralrechner des Datenverarbeitungssystems weiter. Wenn aus Performancegründen kein dedizierter Master-Prozessor erforderlich ist, dann können dessen Aufgaben auch vom Zentralprozessor des Datenverarbeitungssystems übernommen werden.

Bei einer Realisierung des Slave-Prozessors durch einen Mikroprozessor nebst maskenprogrammiertem ROM oder ladbarem RAM-Programmspeicher ergibt sich eine große Flexibilität bei Konstruktion und Benutzung bei gleichzeitigem geringem Designaufwand. Bei einem einfacheren, fest vorgegebenen Repertoire an Suchanfragen wie z.B. Stringmatching mit Strings vorgegebener Maximallänge oder Regular Expression Matching mit Regular Expressions einer vorgegebenen maximalen Komplexität kann man auch eine dedizierte Schaltungsanordnung dafür konstruieren. Dadurch minimiert sich der Aufwand an benötigter Chipfläche. Bei höchsten Performanceanforderungen und sehr komplexen Suchfragen könnte auch eine Realisierung mit speicherprogrammierten PLD-Strukturen zum Einsatz kommen.

Zur beschleunigten Erledigung von Suchanfragen können die Slave-Prozessoren spezielle Datenstrukturen anlegen, die diese Aufgabe unterstützen. Solche Datenstrukturen können beispielsweise Indexlisten von Schlagworten, invertierte Listen usw. sein. Dafür sind reservierte Speicherbereiche auf der Chipkarte vorzusehen. Die Art und Organisation dieser Datenstrukturen wird dabei zweckmäßigerweise vom Master-Prozessor vorgegeben, die Erstellung kann autonom durch die Slave-Prozessoren erfolgen, z.B. in Phasen geringen Auftragsvolumens.

Das Protokoll zwischen Master- und Slave-Prozessor kann auf verschiedenen Ebenen angesiedelt werden. Zunächst kann ein bestimmtes Repertoire an Suchanfragen bzw. Verwaltungsoperationen definiert werden, die der Slave-Prozessor autonom ausführen kann. Die Befehlsübergabe vom Master- zum Slave-Prozessor erfolgt dann nach dem üblichen Schema für Peripheriekomponenten in Rechnern. Auch die erfolgreiche Bearbeitung kann nach einem der üblichen Schemata mitgeteilt werden. Dabei kommt eine aktive Rückmeldung oder eine passive Rückmeldung nach Polling durch den Master-Prozessor in Frage. Bei der aktiven Rückmeldung gibt die jeweilige Chipkarte auf einer dafür vorgesehenen Leitung bekannt, daß sie einen Suchtreffer hat. Zur schnelleren Identifizierung der Chipkarte durch den Master-Prozessor enthält die Rückmeldung zweckmäßigerweise auch ihre Identität analog zum vektorisierten Interrupt in Rechnern. Bei Polling befragt der Master-Prozessor der Reihe nach alle Chipkarten nach dem Suchergebnis. Die Karten melden daraufhin den Suchstatus und gegebenenfalls das Suchergebnis zurück.

Ein allgemeineres Protokoll zwischen Master- und Slave-Prozessor folgt dem Schema der Kanalprozessoren in Mainframe-Computern. Hier wird kein Repertoire an Suchfragen vordefiniert, vielmehr sendet der Master- an den Slave-Prozessor das auszuführende Suchprogramm in einer geeigneten Programmiersprache wie z.B Assembler oder SQL etc. Der weitere Ablauf erfolgt analog zur ersten Alternative. Gegenüber dieser ergibt sich hier eine größere Flexibilität und immanente Erweiterbarkeit des Suchrepertoires.

## Patentansprüche

1. Tragbare Datenträgeranordnung mit einem elektrisch programmierbaren, nicht-flüchtigen Halbleiterspeicher, auf den über Kontaktflächen auf Oberflächen der Datenträgeranordnung zugegriffen werden kann,
**dadurch gekennzeichnet,**
daß die Kontaktflächen derart angeordnet sind, daß durch Aufeinanderlegen solcher tragbaren Datenträgeranordnungen ein Kontakt zu den jeweils benachbarten tragbaren Datenträgeranordnungen hergestellt wird und gleichzeitig ein Kontakt zu einem Bussystem möglich ist, um eine Vielzahl solcher tragbaren Datenträgeranordnungen an dem Bussystem betreiben zu können.

2. Tragbare Datenträgeranordnung nach Anspruch 1, **dadurch gekennzeichnet,** daß sie Mittel aufweist, die ein Suchen nach bestimmten Daten im nicht-flüchtigen Speicher ermöglichen.

3. Tragbare Datenträgeranordnung nach Anspruch 1 oder 2, **dadurch gekennzeichnet,** daß die Suchmittel mit einem Mikroprozesor gebildet sind.

4. Datenträgeranordnung nach Anspruch 2 oder 3,
**dadurch gekennzeichnet,** daß die Suchmittel derart ausgebildet sind, daß die Datenträgeranordnung mittels ihrer Suchmittel selbsttätig bestimmte Daten suchen und diese in vorgegebenen Dateien im nicht-flüchtigen Speicher ablegen kann.

5. Verwendung einer tragbaren Datenträgeranordnung gemäß einem der Ansprüche 1 bis 4 zur Archivierung von Daten.

6. Datenverarbeitungssystem,
das einen mit einem Bussystem verbundenen Adapter und zumindest eine mit dem Adapter verbundene Datenträgeranordnung nach einem der Ansprüche 1 bis 4 aufweist.

7. Datenverarbeitungssystem nach Anspruch 5, **dadurch gekennzeichnet,** daß der Adapter einen Mikroprozessor aufweist.

8. Datenverarbeitungssystem nach Anspruch 6, **dadurch gekennzeichnet,** daß der Mikroprozessor des Adapters ein Masterprozessor und der Mikroprozessor der Datenträgeranordnung ein Slaveprozessor ist.

## Claims

1. Portable data carrier arrangement having an electrically programmable, non-volatile semiconductor memory, to which access can be made via contact areas on surfaces of the data carrier arrangement, characterized in that the contact areas are arranged in such a way that by laying such portable data carrier arrangements one on top of the other a contact is produced with the respectively neighbouring portable data carrier arrangements and at the same time a contact is possible with a bus system in order to be able to operate a multiplicity of such portable data carrier arrangements on the bus system.

2. Portable data carrier arrangement according to Claim 1, characterized in that it has means which permit a search for certain data in the non-volatile memory.

3. Portable data carrier arrangement according to Claim 1 or 2, characterized in that the searching means are formed by a microprocessor.

4. Data carrier arrangement according to Claim 2 or 3, characterized in that the searching means are designed in such a way that the data carrier arrangement can automatically search by means of its searching means for certain data and can store them in given files in the non-volatile memory.

5. Use of a portable data carrier arrangement according to one of Claims 1 to 4 for the archiving of data.

6. Data processing system, which has an adapter, connected to a bus system, and at least one data carrier arrangement according to one of Claims 1 to 4, connected to the adapter.

7. Data processing system according to Claim 5, characterized in that the adapter has a microprocessor.

8. Data processing system according to Claim 6, characterized in that the microprocessor of the adapter is a master processor and the microprocessor of the data carrier arrangement is a slave processor.

## Revendications

1. Dispositif de support de données portable comportant une mémoire à semi-conducteur non volatile, qui peut être programmée électriquement et à laquelle on peut accéder par l'intermédiaire de surfaces de contact ménagée à la surface du dispositif de support de données, caractérisé en ce que les surfaces de contact sont disposées de telle manière que, en empilant des dispositifs de support de données portable de ce genre, il est produit un contact avec les dispositifs de support de données portable voisins et, en même temps, un contact avec un système de bus est possible afin de pouvoir faire fonctionner sur le système de bus une pluralité de dispositifs de support de données portable de ce genre.

2. Dispositif de support de données portable suivant la revendication 1, caractérisé en ce qu'il comporte des moyens qui permettent une recherche de données déterminées dans la mémoire non volatile.

3. Dispositif de support de données portable suivant la revendication 1 ou 2, caractérisé en ce que les moyens de recherche sont formés par un microprocesseur.

4. Dispositif de support de données suivant la revendication 2 ou 3, caractérisé en ce que les moyens de recherche sont réalisés de telle manière que le dispositif de support de données peut rechercher automatiquement des données déterminées au moyen de ces moyens de recherche et les enregistrer dans des fichiers prescrits de la mémoire non volatile.

5. Utilisation d'un dispositif de support de données suivant l'une des revendications 1 à 4 pour archiver des données.

6. Système de traitement de données qui comporte un adaptateur relié à un système de bus et au moins un dispositif de support de données, suivant l'une des revendications 1 à 4, relié à l'adaptateur.

7. Système de traitement de données suivant la revendication 5, caractérisé en ce que l'adaptateur comprend un microprocesseur.

8. Système de traitement de données suivant la revendication 6, caractérisé en ce que le microprocesseur de l'adaptateur est un processeur maître et le microprocesseur du dispositif de support de données est un processeur esclave.
